# EUROPÄISCHE PATENTSCHRIFT

(11) **EP 3 618 993 B1**
(45) Veröffentlichungstag und Bekanntmachung des Hinweises auf die Patenterteilung: **07.07.2021**
(21) Anmeldenummer: 18722992.7
(22) Anmeldetag: 07.05.2018
(51) Int. Cl.: B23K 1/00, B23K 1/20, B23K 3/08, B23K 37/04, H05K 3/32, H05K 3/34, B23K 101/42

(54) **VERFAHREN ZUM HERSTELLEN EINER LÖTVERBINDUNG VON BAUTEILEN UNTER VERWENDUNG VON HAFTMATERIAL FÜR PROVISORISCHE VERBINDUNG DER BAUTEILE**
METHOD OF PRODUCING A SOLDER CONNECTION OF COMPONENTS USING ADHESIVE MATERIAL FOR TEMPORARY CONNECTION OF THE COMPONENTS
PROCÉDÉ DE RÉALISATION D'UNE LIAISON BRASÉE ENTRE DES ÉLÉMENTS PAR UTILISATION D'UN MATÉRIAU ADHÉSIF POUR LA LIAISON PROVISOIRE ENTRE CES ÉLÉMENTS

(30) Priorität: 05.05.2017 DE 102017109747; 28.08.2017 DE 202017105174 U
(43) Veröffentlichungstag der Anmeldung: 11.03.2020
(73) Patentinhaber: PINK GmbH Thermosysteme, 97877 Wertheim (DE)
(72) Erfinder: HUTZLER, Aaron, 10709 Berlin (DE); OETZEL, Christoph, 97877 Wertheim (DE)
(74) Vertreter: Spachmann, Holger
(86) Internationale Anmeldenummer: PCT/EP2018/061727
(87) Internationale Veröffentlichungsnummer: WO 2018/202919

(56) Entgegenhaltungen:
- JP-A- 2016 183 102
- US-A- 5 881 453
- US-A1- 2013 102 112
- US-A1- 2015 314 385
- US-A1- 2016 340 242

## Beschreibung

Die vorliegende Erfindung betrifft ein Verfahren zum Herstellen einer Lötverbindung zwischen mehreren Bauteilen in einer von der Umgebung abgeschlossenen Prozesskammer durch Erhitzen und Aufschmelzen von Lotmaterial, welches zwischen den zu verbindenden Bauteilen angeordnet ist (siehe US 2015/314385 A1, der den Oberbegriff des Anspruchs 1 beschreibt).

### STAND DER TECHNIK

Unter dem Begriff "Bauteile" werden allgemein Schaltungsträger, Substrate, Substratträger, Grundplatten, Werkstückträger, Montageträger oder dergleichen aus Metall, Keramik, Kunststoff oder anderen Materialien oder beliebigen Materialkombinationen sowie darauf zu befestigende Bauelemente wie Leistungshalbleiterchips, (Halbleiter-) Baugruppen oder dergleichen verstanden.

Mittels eines gattungsgemäßen Verfahrens werden insbesondere großflächige Lötungen hergestellt, bei denen beispielsweise Halbleiterbauelemente, Mikroelektronikbauteile oder Leistungshalbleiterchips, wie z. B. Transistoren oder Dioden auf Leiterplatten, IGBTs, MOSFETs oder Dioden auf metallisierte Keramiksubstrate oder sonstige Schaltungsträger gelötet bzw. miteinander verlötet werden, oder bei denen metallisierte Keramiksubstrate auf metallische Grundplatten und/oder Kühlkörper gelötet werden. Auch Leiterplatten, welche mit Kühlkörpern verbunden werden sollen, können in einer gattungsgemäßen Lotvorrichtung gelötet werden.

Um ein optimales Lötergebnis zu erzielen, wird angestrebt, das aufgeschmolzene Lot zusammen mit den zu verbindenden Bauteilen kontrolliert über den Schmelzpunkt des Lotes, auch bei Überdruck von größer 1013mbar zu erwärmen und anschließend kontrolliert unter den Erstarrungspunkt des Lotes abzukühlen, um die Bauteile lunkerfrei miteinander zu verbinden.

Das Herstellen von Lötverbindungen erfolgt in der Regel in einer von der Umgebung abgeschlossenen, insbesondere evakuierbaren Prozesskammer, in welcher eine Lötvorrichtung angeordnet ist, welche eine Basisplatte und eine Andruckplatte umfasst, zwischen denen eine das oder die Bauteile und das Lotmaterial umfassende Lötgruppe aufgenommen ist. Die Basisplatte und die Andruckplatte sind zum Ausüben einer Presskraft auf die Lötgruppe relativ zueinander bezüglich ihres Abstandes verstellbar. Zugleich können die Andruckplatte und/oder die Basisplatte das Erhitzen und/oder das Abkühlen der Bauelemente und des Lotmaterials bewirken. Hierzu können die genannten Platten mit entsprechenden Wärmequellen und/oder Wärmesenken thermisch gekoppelt sein.

In der Regel werden die Bauteile und das Lotmaterial, welches beispielsweise in Form von Lötplättchen oder als Lotpulver vorliegen kann, vor dem Einbringen in die Prozesskammer zu einem Stapel zusammengefügt.

Bei der erforderlichen Handhabung der Bauteile außerhalb und/oder innerhalb der Prozesskammer und auch während des eigentlichen Lötvorgangs besteht jedoch die Gefahr, dass sich die zu Bauteile nach dem Erstarren des aufgeschmolzenen Lotmaterials relativ zueinander nicht in der gewünschten Position befinden. Abweichungen können sowohl bezüglich einer Lateralposition der Bauteile als auch bezüglich des Abstands zueinander entstehen.

In der US 4 801 069 A ist ein Verfahren und eine Anordnung zum Lötverbinden von Bauteilen in einer Gasatmosphäre dargestellt, wobei in einem ersten Schritt ein Lötplättchen mittels eines Haftmaterials auf einer Platine als Schaltungsträger platziert und zumindest temporär mittels Erwärmung befestigt wird, und in einem nachfolgenden Schritt ein zu verlötendes Bauteil auf den Lötplättchen und dem Schaltungsträger mit einem weiteren Haftmaterial unter Druckbeaufschlagung temporär vor einem Lötvorgang befestigt wird. Der Vorgang ist mehrstufig und beinhaltet ein wiederholtes Erwärmen und Abkühlen der Komponenten, so dass zum einen ein energetisch aufwändiger und thermisch belastender Bearbeitungsvorgang vorliegt, dessen Prozesszeiten relativ lang sind. Aufgrund der mehrstufigen Anordnungsschritte kann es leicht zu Fehlpositionierungen kommen. Eine Umsetzung des Verfahrens unter Vakuumatmosphäre ist aufgrund der Mehrstufigkeit des Verfahrens nicht umsetzbar.

In der US 2009 / 0 085 227 A1 wird ein Verfahren und eine Vorrichtung zum Flip-Chip Verbinden eines Bauteils mit einem Schaltungsträger vorgeschlagen, bei dem ein vordefinierter Abstand durch eine Aufbringungsvorrichtung mit einem Aufsetzrahmen erreicht wird, der durch einen Vakuumstempel geführt ein zu verbindendes Bauteil auf einen Schaltungsträger aufsetzt. Nach einer Positionierung des zu verbindenden Bauteils auf dem Schaltungsträger mittels des Aufsetzrahmens erfolgt eine Verbindung durch Erhitzen eines dazwischenliegenden Lötpulverharzes, wobei sich eine Gasatmosphäre des Lötmaterials ausbildet, das mittels Konvektion ausgast, so dass nur zu verbindende Kontaktflächen verlötet werden. Dazu wird weder ein Haftvermittler für ein temporäres Ausrichten und Befestigen, noch eine während und nach dem Fügevorgang erfolgende weitere Druckbeaufschlagung vorgeschlagen, um nachträglich einen Mindestabstand und eine Ausrichtung zueinander aufrechtzuerhalten.

Aus der US 5 175 410 A ist eine Niederhaltevorrichtung für die elektrischen Kontaktbeine eines zu verlötenden Bauteils auf einem Schaltungsträger für eine Chip-On-Tape Montage bekannt, wobei die Niederhaltevorrichtung vom Bauteil umfangsmäßig abstehenden Kontaktbeine auf die Oberfläche des Schaltungsträger beim Lötvorgang verpresst. Äußere Anpressstege sollen die zu verlötenden Endbereiche der Kontaktbeine auf die Lötflächen des Schaltungsträgers pressen, während innere Anpressstege unmittelbar am Gehäuse des zu verlötenden Bauteils ansetzen. Es werden daher nur selektive, zu verbindende Bereiche des Bauteils unmittelbar auf den Schaltungsträger gepresst, und keine vordefinierbare Bauhöhe der Gesamtlötgruppe ermöglicht, auch ist ein gesteuertes verlöten von Bereichen zwischen Bauteil und Schaltungsträger hierdurch nicht möglich. Die Niederhaltevorrichtung ist nur für Bauteile mit umfangsmäßig außenliegenden Kontaktbeinen einsetzbar.

Es ist die Aufgabe der Erfindung, ein Verfahren der eingangs genannten Art zu schaffen, bei dem die Bauteile mit verbesserter Maßhaltigkeit schneller und kostengünstiger miteinander verbunden werden können.

### GEGENSTAND DER ERFINDUNG

Die Lösung der Aufgabe erfolgt durch ein Verfahren mit den Merkmalen des Anspruchs 1. Vorteilhafte Ausgestaltungen des Verfahrens sind Gegenstand der Unteransprüche.

Es wird vorgeschlagen, dass die zu verbindenden Bauteile provisorisch mit einem Haftmaterial zu einer Lötgruppe verbunden werden, in welcher die Bauteile relativ zueinander in einer Fügeposition fixiert sind. Dadurch wird verhindert, dass die Bauteile während der Zusammenstellung zu der Lötgruppe und/oder während der Handhabung der Lötgruppe, beispielsweise beim Einbringen in die Prozesskammer, gegeneinander verrutschen.

Das provisorische Verbinden der Bauteile durch das Haftmaterial erfolgt vorteilhafterweise durch Adhäsionskräfte, die an den Grenzflächen zwischen dem Haftmaterial und den Bauteilen bzw. dem Lotmaterial wirksam werden.

Gemäß einer vorteilhaften Ausgestaltung ist das Haftmaterial derart gewählt, dass es während des Herstellens der Lötverbindung rückstandslos verdampft. Dadurch wird gewährleistet, dass die Qualität der Lötverbindung nicht durch etwaige Rückstände des Haftmaterials beeinträchtigt wird.

Das Haftmaterial kann vor oder während des Positionierens der Bauelemente auf dem Werkstückträger flächig aufgesprüht oder gezielt, z.B. in Art einer X-Y-Plottervorrichtung an dafür vorgesehene, vorher festgelegte Stellen und Bereiche der Bauelemente, des Substratträgers und/oder des Werkstückträgers gezielt punkt-, linienförmig oder flächig aufgebracht werden. Das Auftragen des Haftmaterials erfolgt vorzugsweise automatisiert, um eine Serienfertigung mit hohem Durchfluss zu ermöglichen.

Vorzugsweise wird das Lötverfahren mit Lotplättchen, sogenannten Preforms durchgeführt, wobei auf die Verwendung von Lotpaste, die ggf. Flussmittel enthält, verzichtet werden kann.

Gemäß einer weiteren vorteilhaften Ausgestaltung ist die Verdampfungstemperatur des Haftmaterials bei einem Verdampfungsdruck, welcher geringer ist als der atmosphärische Druck, niedriger ist als die Schmelztemperatur des Lotmaterials bei atmosphärischem Druck oder auch bei Überdruck über 1013 mbar. Dadurch ist gewährleistet, dass das Haftmaterial bereits vor dem Aufschmelzen des Lotmaterials vollständig verdampfen kann. Dafür ist es nicht zwingend notwendig, dass die Verdampfungstemperatur des Haftmaterials bei atmosphärischem Druck niedriger ist als die Schmelztemperatur des Lotmaterials, sie kann auch höher sein.

Gemäß der Erfindung ist vorgesehen, dass die Lötgruppe auf eine Zwischentemperatur erhitzt wird, welche niedriger ist als die Schmelztemperatur des Lotmaterials bei atmosphärischem Druck oder auch bei Überdruck über 1013 mbar, und dass der Druck in der Prozesskammer auf einen Druck unterhalb des Verdampfungsdrucks bei der Zwischentemperatur abgesenkt wird, so dass das Haftmaterial verdampft. Das Absenken des Drucks in der Prozesskammer kann vorteilhafterweise erst dann erfolgen, wenn die Lötgruppe auf die Zwischentemperatur erhitzt wurde. Es ist jedoch auch möglich, den Druck bereits vor dem Erreichen der Zwischentemperatur abzusenken. Die Absenkung des Drucks kann kontinuierlich oder in Stufen erfolgen. Es sollte jedoch gewährleistet sein, dass vor dem Aufschmelzen des Lotmaterials das Haftmaterial verdampfen konnte.

Weiter gemäß der Erfindung ist vorgesehen, dass der Druck in der Prozesskammer zunächst auf einen Druck oberhalb des Verdampfungsdrucks des Haftmaterials bei der Zwischentemperatur abgesenkt wird, so dass das Haftmaterial noch nicht verdampft, dass nachfolgend ein Reinigungsmittel, insbesondere Methansäure, Wasserstoff oder ein Plasma, zum Reinigen der Lötgruppe in die Prozesskammer eingeleitet wird, und dass nachfolgend der Druck in der Prozesskammer auf einen Druck unterhalb des Verdampfungsdrucks des Haftmaterials bei der Zwischentemperatur abgesenkt wird. Unter dem Einleiten eines Plasmas in die Prozesskammer wird insbesondere auch ein Erzeugen des Plasmas in der Prozesskammer selbst verstanden, wobei gegebenenfalls eine geeignete, zu ionisierende Substanz in die Prozesskammer eingeleitet werden kann. Bei dieser Ausgestaltung besteht der Vorteil darin, dass auch während des Reinigungsvorgangs noch eine provisorische Verbindung zwischen den Bauteilen und/oder dem Lotmaterial besteht. Beim Absenken des Drucks in der Prozesskammer auf einen Druck unterhalb des Verdampfungsdrucks des Haftmaterials bei der Zwischentemperatur können das Haftmaterial und das Reinigungsmaterial gemeinsam aus der Prozesskammer ausgeleitet werden.

Gemäß einer weiteren vorteilhaften Ausgestaltung kann die Zwischentemperatur während des Absenkens des Drucks in der Prozesskammer auf einen Druck unterhalb des Verdampfungsdrucks des Haftmaterials zumindest bis zum vollständigen Verdampfen des Haftmaterials auf einem vorgegebenen Temperaturwert oder innerhalb eines vorgegebenen Temperaturbereichs gehalten werden. Der genannte Temperaturwert bzw. der genannte Temperaturbereich befinden sich stets unterhalb der Schmelztemperatur bei Normaldruck oder auch bei Überdruck über 1013 mbar. Dadurch wird die Gefahr, dass sich beim Aufschmelzen des Lotmaterials noch Haftmaterial an der Lötgruppe befindet, weiter vermindert.

Gemäß einer weiteren vorteilhaften Ausgestaltung kann vorgesehen werden, dass das Haftmaterial im Bereich von Kanten und/oder Ecken und/oder der Mitte bzw. im Mittenbereich der zu verbindenden Bauteile und/oder des Lötmaterials angeordnet wird. Auf diese Weise kann das Haftmaterial sehr einfach aufgebracht werden.

Gemäß einer vorteilhaften Ausführungsform ist vorgesehen, dass das Aufschmelzen des Lotmaterials nach dem Verdampfen des Haftmaterials erfolgt, um Verunreinigungen des Lotmaterials zu verhindern.

Gemäß einer weiteren vorteilhaften Ausgestaltung kann vorgesehen sein, dass das Haftmaterial flüssig oder pastös ist und insbesondere einen Terpenalkohol, insbesondere Isobornyl-Cyclohexanol, umfasst. Der gewünschte flüssige oder pastöse Aggregatzustand soll zumindest bei Raumtemperatur und atmosphärischem Druck vorliegen.

Als Haftmaterial können auch geeignete Gemische oder Lösungen verschiedener Substanzen verwendet werden. Insbesondere kann auch dem Haftmaterial ein Füll- oder Verdickungsmittel zugesetzt werden. Es sollte jedoch sichergestellt werden, dass auch die gegebenenfalls bei Raumtemperatur und atmosphärischem Druck festen Bestandteile des Haftmaterials bei erhöhter Temperatur und abgesenktem Druck entsprechend den vorstehend genannten Bedingungen vor dem Aufschmelzen des Lotmaterials verdampfen können.

Gemäß einer weiteren vorteilhaften Ausgestaltung ist vorgesehen, dass die Lötgruppe zumindest während des Aufschmelzens des Lotmaterials in einer in der Prozesskammer angeordneten Lötvorrichtung aufgenommen ist, wobei die Lötvorrichtung eine Basisplatte und eine Andruckplatte, zwischen denen die Lötgruppe aufgenommen ist und welche zum Ausüben einer Presskraft auf die Lötgruppe relativ zueinander bezüglich ihres Abstandes verstellbar sind, sowie eine Anschlagvorrichtung aufweist, welche den Abstand zwischen der Basisplatte und der Andruckplatte auf einen Mindestabstand begrenzt, so dass die Lötgruppe nach dem Aufschmelzen des Lotmaterials eine vorgegebene Dicke aufweist. Die Lötvorrichtung gewährleistet, dass die Bauteile und das Lotmaterial gegeneinander vorgespannt werden und nach dem Aufschmelzen des Lotmaterials noch weiter zusammengepresst werden, da das geschmolzene Lotmaterial sich weiter zwischen den Bauteilen verteilen kann und gegebenenfalls dort vorhandene kleine Zwischenräume auffüllt. Die Anschlagvorrichtung begrenzt hierbei das Pressmaß, so dass die Lötgruppe nach dem Erstarren des Lotmaterials eine definierte Dicke oder Höhe aufweist. Dadurch wird die Maßgenauigkeit weiter verbessert, da nicht nur laterale Verschiebungen, sondern auch Abweichungen von einer vorgegebenen Dicke oder Höhe der Bauteilanordnung zuverlässig verhindert werden können. Zudem wird vermieden, dass bei zu starkem Pressen Lotmaterial seitlich zwischen den Bauteilen hervorquellen kann. Die Erfindung unterscheidet sich gegenüber konventionell verwendeten Lötrahmen dahingehend, dass ein direkter berührender Kontakt nur kurzzeitig auftritt, nämlich während der sich das Lot im schmelzflüssigen Zustand befindet oder eine Erstarrungsphase eintritt. Ein dauerhafter bzw. mechanisch fixierender Kontakt wird vermieden, um Schädigungen bzw. Spannungen im Material zu vermeiden.

Besonders vorteilhaft kann die Anschlagvorrichtung in einer Mehrkammeranlage für eine Fließfertigung eingesetzt werden. Eine derartige Anlage umfasst zumindest zwei Kammern, insbesondere drei Kammern für ein Vorheizen, ein Verbinden und ein Abkühlen. Die Anschlagvorrichtung ist vorteilhaft zumindest in der Abkühlkammer vorgesehen, um beim Erstarren des Lotes eine mechanische Ausrichtung bereitzustellen. Weiterhin kann die Anschlagvorrichtung auch in der Lötkammer zum Verbinden der Bauteile eingesetzt werden, und kann auch in der Vorheizkammer zum dem Fügevorgang vorgeschaltete Ausrichtung eingesetzt werden. Hierzu kann vorteilhafterweise die Anschlagvorrichtung mit einem verfahrbaren Werkstückträger durch die Anlage geführt werden.

Gemäß einer vorteilhaften Ausgestaltung ist die Anschlagvorrichtung an der Basisplatte oder der Andruckplatte angeordnet.

Gemäß einer weiteren vorteilhaften Ausgestaltung ist die Anschlagvorrichtung verstellbar, so dass der Mindestabstand einstellbar ist. Dies ermöglicht eine variable Anpassung der Anschlagvorrichtung an unterschiedliche Abmessungen oder an eine unterschiedliche Anzahl der zu verbindenden Bauteile.

Gemäß einer weiteren vorteilhaften Ausgestaltung ist vorgesehen, dass die Anschlagvorrichtung mehrere, insbesondere längenverstellbare Anschlagelemente umfasst. Dadurch kann gewährleistet werden, dass die Maßhaltigkeit über die gesamte laterale Ausdehnung der Lötgruppe eingehalten werden kann. Insbesondere kann ein Verkanten oder Verkippen der Andruck- und Basisplatte relativ zueinander vermieden werden.

Gemäß einer vorteilhaften Ausgestaltung können die Anschlagelemente eine Verstelleinrichtung, insbesondere ein Verstellgewinde aufweisen, welches mit einem an der Basisplatte oder der Andruckplatte vorgesehenen Komplementärverstelleinrichtung, insbesondere einem Komplementärgewinde zusammenwirkt. Dadurch lässt sich die gewünschte Verstellbarkeit der Anschlagvorrichtung auf einfache Weise erzielen.

Gemäß einer weiteren vorteilhaften Ausgestaltung ist vorgesehen, dass die Anschlagelemente derart angeordnet sind, dass sich diese bei Erreichen des Mindestabstands mit einem jeweiligen freien Ende an einem Bauteil der Lötgruppe, an einem eines der Bauteile tragenden Basisrahmen oder der Basisplatte abstützen. Wenn sich die Anschlagelemente an einem Bauteil der Lötgruppe abstützen sollen, sollte dieses Bauteil sinnvollerweise ein Abschlussbauteil sein, welches sozusagen einen Boden oder Deckel des Bauteilestapels bildet und seitlich über die anderen Bauteile der Lötgruppe hervorragt. Die Anschlagelemente können jedoch auch an anderen Baugruppen anschlagen. So können die Anschlagelemente, die z. B. an der Andruckplatte befestigt sind, an einem Basisrahmen, welcher als Bauteileträger verwendet wird, oder sogar an der Basisplatte selbst anschlagen. Der Basisrahmen kann beispielsweise ein Schaltungsträger als Abschlussbauteil der Lötgruppe tragen.

In Löt- und Sinterfügeprozesse in der Elektrotechnik und Elektronik hat ein Temperaturmanagement einen großen Einfluss auf die Qualität, Verlässlichkeit und Lebensdauer eines Erzeugnisses. Während der Abkühlphase des Lotmaterials können beim Aushärten Lotkörner bzw. Lotinseln entstehen, wobei materialspezifische Eigenschaften wie Elastizitätsmodul, Temperaturkoeffizient des Lotmaterials und die Ausrichtung der Korngestalt des Lots einen wesentlichen Einfluss auf die Fügeverbindung haben. Eine Ermüdungseigenschaft der Fügeverbindung hängt wesentlich von einer Größe der Lotkörnung ab. Es hat sich im Rahmen der Erfindung gezeigt, dass eine gezielte Beeinflussung der Korngröße und -orientierung durch ein gezieltes Temperieren während der Heiz- aber insbesondere während der Abkühlphase möglich ist. Hierbei ist es wünschenswert, eine Temperierung nicht nur von einer Unterseite der Bauteile, sondern zur verbesserten Prozessführung auch von oben durchzuführen. Hierdurch können entstehende mechanische Spannungen zwischen den Fügepartnern herabgesetzt, die Ausrichtung verbessert und Verwölbungstendenzen minimiert werden. Somit ist gemäß einer vorteilhaften Ausführungsform die Basisplatte und/oder die Andruckplatte heizbar und/oder kühlbar. Zu diesem Zweck können die Basisplatte und/oder die Andruckplatte eine Wärmequelle und/oder eine Wärmesenke aufweisen, welche in die Basisplatte bzw. in die Andruckplatte integriert sein können. Die Basisplatte und/oder die Andruckplatte können auch mit einer Wärmequelle und/oder einer Wärmesenke, z. B. einer Heiz- und/oder Kühlplatte thermisch koppelbar oder gekoppelt sein. Insbesondere können die Basisplatte und/oder die Andruckplatte derart konfiguriert sein, dass diese im Bereich einer Kontaktfläche mit den Bauteilen einen Temperaturgradienten aufweisen, welche es ermöglicht, die Bauteile derart zu erwärmen und/oder abzukühlen, dass randnahe Bereiche der Bauelemente eine höhere Temperatur aufweisen als randferne Bereiche der Bauelemente. Dadurch wird die Möglichkeit geschaffen, dass das Lotmaterial von innen nach außen, d. h. zu den Rändern hin erstarrt. Während des Abkühlprozesses kann noch flüssiges Lotmaterial von außen nach innen nachfließen. Dadurch wird eine Ausbildung von Lunkern und/oder Hohlräumen im Lotmaterial durch abnehmendes Volumen des Lotmaterials beim Abkühlen vermieden. Eine beispielhafte Ausgestaltung einer derartigen Vorrichtung ist in der Druckschrift WO 2016/091962 A1 offenbart, deren Offenbarungsgehalt durch Bezugnahme vollständig in die vorliegende Anmeldung aufgenommen wird. Hierdurch kann eine Temperaturführung der Bauelemente gezielt von oben erreicht werden. Insoweit ermöglicht die Andruckplatte neben einer mechanischen Ausrichtung eine Temperierungssteuerung durch gezieltes Erwärmen und/oder Abkühlen von der Oberseite der Bauelemente. Dies kann insbesondere beim Sintern, insbesondere Drucksintern als Fügetechnik genutzt werden, so dass auch nach Verlassen einer Sinterpresse sowohl eine Ausrichtung als auch eine Temperatursteuerung ermöglicht wird.

Gemäß des vorgenannten Ausführungsbeispiels einer Temperierungsfunktion der Basisplatte und/oder der Andruckplatte ist es besonders vorteilhaft, die Temperierung insbesondere der Andruckplatte oder von einer Bauteiloberseite zugewandten Oberflächenbereiche der Andruckplatte mittels eines Thermofluids oder mittels eines oder mehrerer Temperierungselemente vorzunehmen. Als Thermofluid kann eine heizbare Flüssigkeit, insbesondere Wasser oder ein Wasser-Glykol-Gemisch vorzugsweise bei erhöhtem Flüssigkeitsdruck von 2-3 Bar oder mehr eingesetzt werden, um eine schnelle Erwärmung oder Abkühlung zu ermöglichen. Ebenfalls vorteilhaft kann ein elektrisches Temperierelement, insbesondere ein elektrischer Heizwiderstand oder ein Kühlungs-Peltierelement oder ähnliches eingesetzt werden. Dabei kann z.B. auch als Heizung ein elektrisches Element und zur Kühlung ein Kühlfluid oder umgekehrt eingesetzt werden. Ebenfalls kann eine Strahlungsheizung z.B. als Infrarotstrahler eingesetzt und so z.B. die Andruckplatte von oben durch IR-Strahler beheizt, vorteilhafterweise auch inhomogen durch IR-Punktstrahler oder durch eine IR-Strahlungsmaske, die nur an ausgewählten Stellen IR-Licht auf die Andruckplatte durchfallen lässt, beheizt werden. Die einzelnen Heiz- und Abkühlelemente können zweckmäßig kombiniert werden. Somit ist eine Zonenbeheizung zu verschiedenen Prozessphasen und in verschiedenen Vorrichtungsbereichen möglich, um eine durchgängige Temperaturführung während des Fügeprozesses sowohl auf der Unterseite als auch auf der Oberseite der Bauelemente zu erreichen.

Besonders vorteilhaft können auf einer temperierbaren Andruckplatte hervorstehende Absätze, insbesondere wärmeleitfähige Absätze und Vorsprünge, aber auch Ausnehmungen und Rückversetzungen ausgebildet sein, um unterschiedliche Höhen von Bauelemente mit Druck zu beaufschlagen und eine gute Wärmekopplung zu erreichen. Die Anschlagelemente können hierzu direkt auf dem Werkstückträger oder der Grundplatte aufsetzen, oder auf weiteren Bauteilkomponenten wie JIGs, Bauteilrahmen etc. Die Vorsprünge und Absätze der Abdeckplatte können gegenüber der Abdeckplatte federnd gelagert sein, so dass der Anpressdruck der Absätze gegenüber der Bauteiloberfläche von einem relativen Abstand der Abdeckplatte von der Bauteiloberfläche abhängt, Hierdurch kann eine frühzeitige Temperierung des Bauelements vor maximaler Druckbeaufschlagung ermöglicht werden, wodurch selektiv eine Lottemperatur im plastifizierten oder in einer flüssigen Phase aufrecht erhalten werden kann, bevor ein maximaler Anpressdruck aufgebracht wird.

Vorteilhafterweise können auch mehrere Andruckplatten, jeweils ausgestattet mit einer Anschlagvorrichtung vorgesehen sein, die entweder gemeinsam oder einzeln gegenüber dem Werkstückträger höhenverstellbar und verfahrbar sind. Somit können einzelne Bauelemente zeitlich versetzt unter Druck gesetzt und zu Temperierzwecken kontaktiert werden. Die Andruckplatten können jeweils einzelne Temperierzonen definieren, oder durch ein einziges Temperiermedium oder eine einzige Temperiervorrichtung eingestellt werden, so dass Bauelemente entsprechend Ihrer Wärmekapazität verschieden thermisch von oben behandelt werden. Bei einer individuellen Verfahrbarkeit der einzelnen Andruckplatten kann der Anpressdruck je nach Bauelementegruppe verschieden eingestellt werden.

Das oder die Anschlagelemente der Anschlagvorrichtung können zur thermischen Kopplung mit Oberflächenbereichen der Bauelemente vorgesehen sein und deren Abmessung und Gestalt kann zum inhomogenen Eintrag von Wärme oder Abfuhr von Wärme spezifisch ausgebildet sein.

Gemäß einer weiteren vorteilhaften Ausgestaltung weist die Lötvorrichtung eine Trägereinheit auf, an dem die Andruckplatte direkt oder indirekt federnd abgestützt oder gelagert ist. Grundsätzlich kann jedoch auch alternativ oder zusätzlich die Basisplatte direkt oder indirekt federnd abgestützt oder gelagert sein. Durch die federnde Abstützung oder Lagerung wird insbesondere gewährleistet, dass sich die Anschlagvorrichtung, insbesondere bei mehreren vorhandenen Anschlagelementen, gleichmäßig mit einer entsprechenden Gegenfläche, d. h. einem Bauteil, der Basisplatte oder dem Basisrahmen abstützen können. Zudem wird verhindert, dass eine Verstellvorrichtung, welche zur Relativverstellung zwischen Basisplatte und Andruckplatte vorgesehen ist, eine unzulässig hohe Presskraft aufbringt und dadurch die Lötvorrichtung beschädigen könnte.

Gemäß einer weiteren vorteilhaften Ausgestaltung kann vorgesehen sein, dass die Federkraft, welche die Andruckplatte auf die Lötgruppe ausübt, einstellbar ist. Dies kann beispielsweise durch austauschbare Federn unterschiedlicher Länge und/oder mit unterschiedlicher Federkonstante erfolgen. Es können auch verstellbare Federn, die beispielsweise die wirksame Länge der Federn einstellen, vorgesehen sein. Dadurch kann die auf die Lötgruppe einwirkende Presskraft zusätzlich zu der Begrenzung der Presskraft durch die Anschlagvorrichtung begrenzt werden.

Gemäß einer weiteren vorteilhaften Ausgestaltung ist die Basisplatte relativ zu der Trägereinheit verstellbar. So ist es z. B. möglich, die Trägereinheit an der Prozesskammer abzustützen, während die Basisplatte verstellt werden kann. Es ist jedoch auch eine umgekehrte Lösung mit einer feststehenden Basisplatte und einer verstellbaren Andruckplatte denkbar.

Gemäß einer weiteren vorteilhaften Ausgestaltung kann vorgesehen sein, dass die der Basisplatte zugeordnete Seite der Andruckplatte planar ist oder zumindest einen hervorstehenden, insbesondere planaren Absatz aufweist, welcher in Kontakt mit der Lötgruppe steht. Vorteilhafterweise ist der hervorstehende Absatz im Querschnitt, d. h. in seiner lateralen Ausdehnung, kleiner als die Lötgruppe bzw. das mit dem Absatz in Kontakt stehende Bauteil, so dass ein lateraler Temperaturgradient zumindest in dem unmittelbar mit dem Absatz in Kontakt stehenden Bauteil erzeugt werden kann.

Ein Einsatz der Erfindung ist insbesondere beim Sintern vorteilhaft, vorzugsweise beim Drucksintern, bei dem durch Einsatz von Druck bei herabgesetzten Temperaturen eine dauerhafte Verbindung der Bauelemente erreicht werden kann. Durch die gezielte Ausrichtung der Bauteile zueinander und eine ermöglichte Höhenkontrolle können Produktionsfehler und mangelhafte Verbindungen deutlich reduziert werden. Insbesondere durch eine weitere gezielte Temperierung mittels der Anschlagvorrichtung von oben kann der Fügeprozess insoweit verbessert werden, als dass gezielt weitere Verfahrensparameter beeinflusst und optimiert werden können.

### ZEICHNUNGEN

Weitere vorteilhafte Ausführungsformen der Erfindung ergeben sich aus der Beschreibung und den Zeichnungen.

Die Erfindung wird nachfolgend anhand von Ausführungsbeispielen mit Bezug auf die Zeichnungen beschrieben. Es zeigen:
- **Fig. 1 und 2**: schematische Darstellungen von Lötgruppen in Seitenansicht und teilweise in Draufsicht, welche gemäß dem erfindungsgemäßen Verfahren mit einem Haftmaterial provisorisch verbunden sind,
- **Fig. 3**: ein schematisches Druck/Temperatur-Diagramm für die Durchführung des Verfahrens,
- **Fig. 4**: ein schematisches Druck/Temperatur-Diagramm für die Durchführung des erfindungsgemäßen Verfahrens,
- **Fig. 5**: ein schematisches Temperatur/Zeit-Diagramm für die Durchführung des Verfahrens,
- **Fig. 6 und 7**: schematische, teilweise geschnittene Seitenansichten einer Lötvorrichtung in verschiedenen Verstellpositionen,
- **Fig. 8**: Seitenansichten verschiedener Lötgruppen, und
- **Fig. 9 und 10**: schematische Darstellungen einer in einer Prozesskammer angeordneten Lötvorrichtung;
- **Fig. 11a, b**: schematische Darstellung einer anderen Lötvorrichtung;

- **Fig. 12a, b**: schematische Darstellung einer weiter anderen Lötvorrichtung;

- **Fig. 13a, b**: schematische Darstellung einer weiteren Lötvorrichtung;

- **Fig. 14a, b**: schematische Darstellung einer anderen Lötvorrichtung.

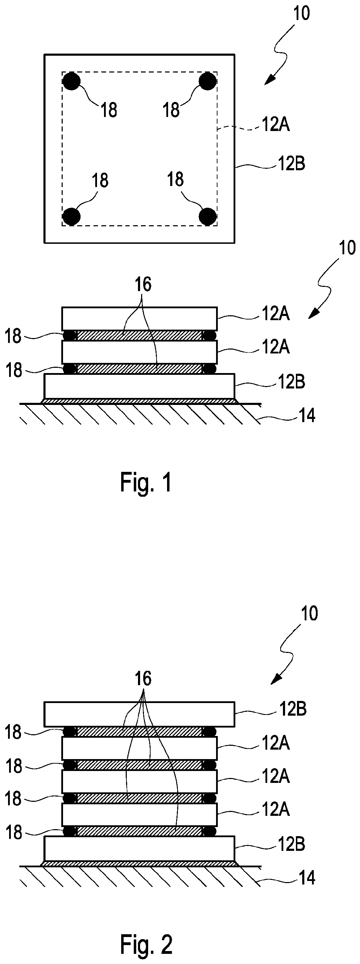

Fig. 1 und 2 zeigen Bauteile 12A, 12B, welche mithilfe von Lotmaterial miteinander verbunden werden sollen. Zwischen den Bauteilen 12A, 12B ist jeweils Lotmaterial 16, beispielsweise in Form eines oder einer Mehrzahl von Lotpads, wie sie beispielsweise bei BGAs, (Ball Grid Arrays) Verwendung finden, angeordnet. Die Bauteile 12A, 12B sind jeweils auf einem weiteren Bauteil in Form eines Schaltungsträgers 14 gestapelt, wobei ein unmittelbar auf dem Schaltungsträgers 14 aufliegendes Bauteil 12B bereits in einem vorhergehenden Schritt mit dem Schaltungsträgers 14 verbunden sein kann oder ebenfalls dort Lotmaterial 16 in noch nicht aufgeschmolzener Form vorgesehen sein kann.

Die Bauteile 12B sind in ihrem Querschnitt gleich oder etwas größer als die Bauteile 12A und können somit allseitig ein wenig über diese hinausragen. Das in Form von Pads angeordnete Lotmaterial 16 ist hingegen im Querschnitt etwas kleiner als die Bauteile 12A, so dass entlang der Ränder der Bauteile 12A bzw. 12B umlaufende schmale Hohlräume bestehen. In diese Hohlräume ist im Bereich der Ecken der Bauteile jeweils Haftmaterial 18 in Form von kleinen Tropfen eingebracht, welches die Bauteile provisorisch zu einer jeweiligen Lötgruppe 10 verbindet. Das Haftmaterial 18 ist vorzugsweise flüssig oder pastös und umfasst insbesondere einen Terpenalkohol, insbesondere Isobornyl-Cyclohexanol. Isobornyl-Cyclohexanol ist beispielsweise unter dem Handelsnamen "Terusolve MTPH" von Nippon Terpene Chemicals, Inc. erhältlich.

Durch das Haftmaterial 18 werden die Bauteile 12A, 12B relativ zueinander durch Adhäsion in einer Fügeposition fixiert, so dass diese zumindest in seitlicher Richtung gegen ein unbeabsichtigtes Verrutschen oder Verschieben, beispielsweise durch Erschütterungen während eines Transfers in eine Prozesskammer, gesichert sind.

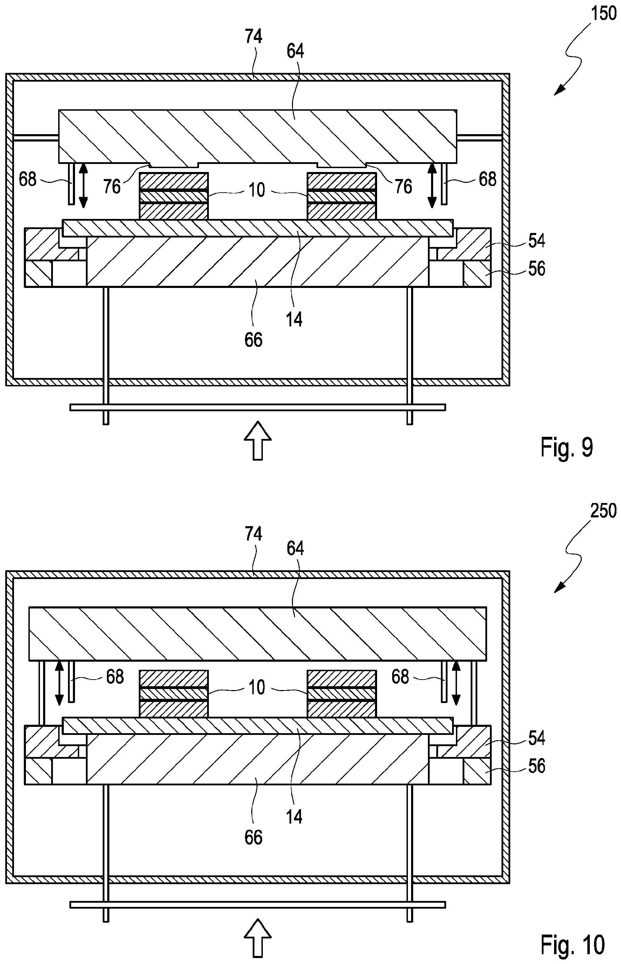

Eine Lötgruppe 10, wie sie in Fig. 1 oder 2 dargestellt ist, kann anschließend in eine Prozesskammer, welche eine Lötvorrichtung umfassen kann, eingebracht werden. Beispielhafte Prozesskammern sind in Fig. 9 und 10 dargestellt und werden nachfolgend noch näher erläutert.

Die Prozesskammer ist von der Umgebung abgeschlossen und weist jeweilige Vorrichtungen auf, welche den Druck in der Prozesskammer verändern bzw. die Bauteile 12A, 12B und das Lotmaterial 16 erwärmen bzw. aufschmelzen können. Weiterhin können in der Prozesskammer weitere Vorrichtungen vorhanden sein, die die verbundenen Bauteile 12A, 12B wieder abkühlen können. Alternativ können auch ein oder mehrere weitere Prozesskammern vorgesehen sein, in welche eine oder mehrere Lötgruppen 10 zum Abkühlen und/oder für weitere Bearbeitungsschritte automatisch oder manuell transferiert werden können.

Nachfolgend wird nun ein Verfahren zum Herstellen einer Lötverbindung zwischen den Bauteilen 12A, 12B gemäß zwei verschiedenen Ausgestaltungen beschrieben.

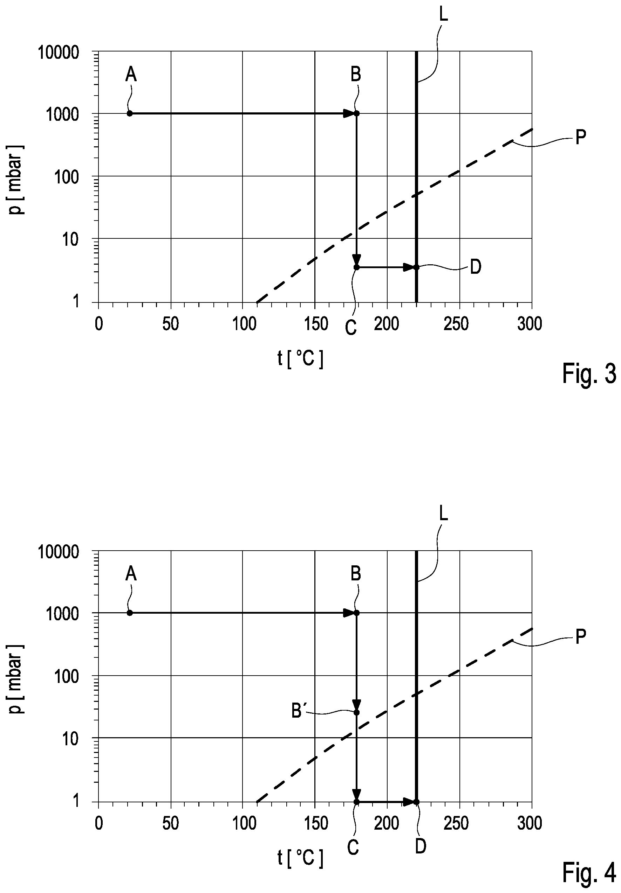

Die Druck/Temperatur-Diagramme (p/t-Diagramme) von Fig. 3 und 4 zeigen in schematischer Weise durch Pfeile gekennzeichnete Änderungen des Drucks und der Temperatur zwischen verschiedenen Prozesspunkten an. Eine Liquiduskurve L stellt die Phasengrenzlinie zwischen dem festen und flüssigen Aggregatzustand des Lotmaterials 16, beispielsweise eines Zinn-Silber-KupferLots, dar und verläuft annähernd druckunabhängig bei einer Temperatur von ca. 220 °C. Eine Phasengrenzlinie P kennzeichnet den Übergang des Haftmaterials 18 von der flüssigen Phase in die Dampfphase in Abhängigkeit von Temperatur und Druck, wobei das Haftmaterial 18 links oberhalb der Kurve in flüssiger Phase und rechts unterhalb der Kurve in der Dampfphase vorliegt.

Für Isobornyl-Cyclohexanol als Haftmaterial 18, dem die dargestellten p/t-Diagramme zugrunde liegen liegt der Siedepunkt bei atmosphärischem Druck zwischen 308 °C und 313 °C. Durch Reduzieren des Drucks in der Prozesskammer kann der Siedepunkt des Haftmaterials unter den Schmelzpunkt des Lotmaterials abgesenkt werden. Dies ermöglicht es, die Lötgruppe 10 bis nah an den Schmelzpunkt des Lotmaterials 16 zu erhitzen, ohne dass das Haftmaterial 18 bereits verdampft.

Ausgehend von einem Prozesspunkt A, bei dem atmosphärischer Druck und Raumtemperatur vorliegt, wird zunächst lediglich die Temperatur erhöht, bis in einem Prozesspunkt B eine Temperatur von etwa 180 °C erreicht wird.

Gemäß Fig. 3 wird nun anschließend in einem nächsten Schritt der Druck in der Prozesskammer abgesenkt, bis ein Prozesspunkt C bei 180 °C und einem Druck zwischen 1 und 10 mbar erreicht wird. Beim Übergang von Prozesspunkt B nach Prozesspunkt C wird die Phasengrenzlinie P überschritten, so dass das Haftmaterial 18 verdampft und aus der Prozesskammer ausgeleitet werden kann.

Anschließend kann ein Reinigungsmittel in die Prozesskammer eingeleitet werden, beispielsweise Methansäure, Wasserstoff oder ein Plasma eingeleitet oder erzeugt werden, um die zu verbindenden Bauteile 12A, 12B zu reinigen.

Nun kann in einem nächsten Schritt die Temperatur von 180 °C auf die Schmelztemperatur des Lotmaterials 16 von 220 °C oder mehr erhöht werden, so dass der Prozesspunkt D erreicht wird.

Entsprechend der Erfindung und gemäß Fig. 4 wird in Abweichung von dem ersten Fall gemäß Fig. 3 nach dem Erreichen des Prozesspunkts B der Druck lediglich soweit reduziert, bis ein Prozesspunkt B' erreicht ist, welcher sich noch knapp oberhalb der Phasengrenzlinie P des Haftmaterials 18 befindet, d. h. noch innerhalb der flüssigen Phase des Haftmaterials. Der Prozesspunkt B' befindet sich beispielsweise bei einer Temperatur von 180 °C und einem Druck zwischen 10 und 100 mbar.

Wenn der Prozesspunkt B' erreicht ist, wird, wie zuvor beschrieben, Reinigungsmittel in die Prozesskammer eingeleitet, um die Bauteile 12A, 12B von Verschmutzungen zu reinigen. Im Unterschied zum ersten Fall (siehe Figur 3) verdampft bei dem Prozesspunkt B' das Haftmaterial 18 noch nicht. Nach erfolgter Reinigung wird der Druck bei weitgehend konstanter Temperatur weiter vermindert, bis der Prozesspunkt C mit einer Temperatur von 180 °C und einem Druck zwischen 1 und 10 mbar erreicht ist. Das Haftmaterial 18 beginnt nun zu verdampfen und wird zusammen mit dem Reinigungsmittel aus der Prozesskammer ausgeleitet.

Nun wird bei annähernd gleichbleibendem Druck die Temperatur der Lötgruppe 10 erhöht, bis im Prozesspunkt D die Liquiduskurve L erreicht bzw. überschritten wird und das Lotmaterial 18 aufschmilzt und sich mit den Bauteilen 12A, 12B verbindet.

An dieser Stelle sei angemerkt, dass der Übergang zwischen den verschiedenen Prozesspunkten A, B, B', C, D nur schematisch ist. So können Temperatur und Druck zumindest abschnittsweise auch gleichzeitig verändert werden, so dass sich die Zustände nicht zwingend isotherm bzw. isobar ändern müssen. Es wird jedoch angestrebt, vor dem Einstellen der Bedingungen, welche ein Verdampfen des Haftmaterials 18 bewirken, die Temperatur der Lötgruppe 10 der Liquidustemperatur des Lotmaterials 16 möglichst weit anzunähern, um die Zeitspanne, in der das Haftmaterial 18 bereits verdampft ist, die Bauteile jedoch noch nicht verbunden sind, möglichst zu minimieren.

Es versteht sich ferner, dass es während des Prozesses auch zu Druckabweichungen kommen kann, die durch ein Verdampfen von Haftmaterial 18 und/oder Lösungs- oder Reinigungsmitteln entstehen, da entsprechende Vakuumeinrichtungen der Prozesskammer anfallendes Gas nur zeitverzögert aus der Prozesskammer ausleiten können.

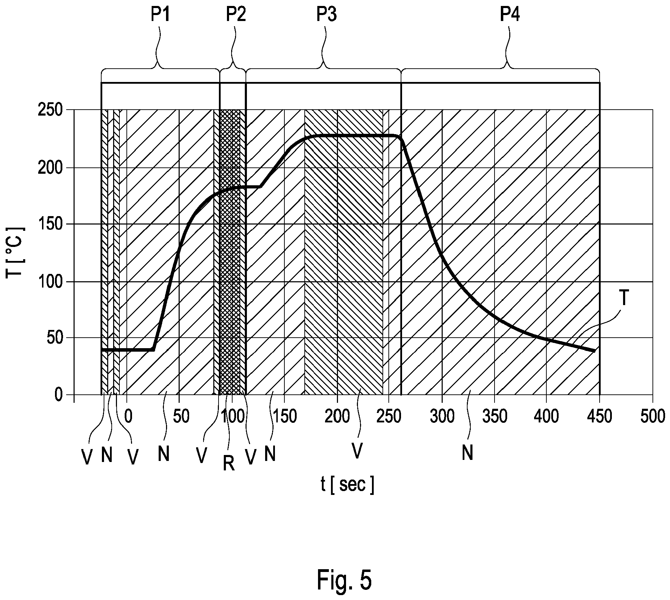

Anschließend wird mit Bezug auf Fig. 5 ein beispielhaftes Temperatur/ZeitDiagramm dargestellt, in dem der zeitliche Verlauf der Temperatur der Lötgruppe durch eine Temperaturkurve T angegeben ist.

Der Lötprozess kann in verschiedene Prozessphasen P1 bis P4 unterteilt werden, die in Fig. 5 entsprechend markiert sind. In dem Diagramm sind ferner verschiedene Bereiche oder Zeiträume markiert, in denen in der Prozesskammer bestimmte Atmosphärenzustände vorherrschen. Bereiche, in denen eine Stickstoffatmosphäre vorliegt, sind mit dem Bezugszeichen N gekennzeichnet, Bereiche, in denen Vakuum (mit unterschiedlichen Drücken) vorherrscht, sind mit dem Bezugszeichen V und ein Bereich, in dem eine Reinigungsmittelatmosphäre vorliegt, ist mit dem Bezugszeichen R gekennzeichnet.

Während einer Vorheizphase P1 wird die Temperatur der Lötgruppe auf 160 °C bis 180 °C erhöht. Während der überwiegenden Zeit der Vorheizphase P1 liegt eine Stickstoffatmosphäre N vor, wobei zum Ende der Vorheizphase P1 kurzfristig ein Vakuum V geschaffen wird.

Anschließend schließt sich die Reinigungsphase P2 an, in der eine Reinigungsmittelatmosphäre R vorherrscht und lediglich zum Ende eine kurze Zeit ein Vakuum V erzeugt wird. Diese kurze Vakuumphase kennzeichnet das Ausleiten des verdampften Haftmaterials bzw. des Reinigungsmittels. Die Temperatur ändert sich während der Reinigungsphase P2 nur noch wenig.

Die Vorheizphase P1 und die Reinigungsphase P2 erfolgen vorteilhafterweise in einer ersten Kammer (Vorheizkammer) einer Mehrkammeranlage.

Anschließend erfolgt während der Schmelzphase P3 eine Temperaturerhöhung auf die Schmelztemperatur des Lotmaterials von etwa 220 °C, wobei zunächst eine Stickstoffatmosphäre N vorliegt, welche bei Erreichen der Schmelztemperatur durch ein Vakuum V abgelöst wird. Zum Ende der Schmelzphase P3 wird wieder Stickstoff in die Prozesskammer eingeleitet, wobei diese Stickstoffatmosphäre N auch während der darauffolgenden Kühlphase P4, in welcher die Temperatur auf unter 50 °C gesenkt wird, erhalten bleibt.

Die Schmelzphase P3 erfolgt vorteilhafterweise in einer zweiten Kammer (Lötkammer) und die Kühlphase P4 in einer dritten Kammer (Abkühlkammer), wobei die beiden Phasen P3 und P4 auch in einer einzigen Kammer ablaufen können.

Vorteilhafterweise können die einzelnen Kammern gegeneinander gasdicht getrennt werden, und es ist eine Durchlaufeinrichtung zur Durchführung der Werkstückträger durch die einzelnen Kammern vorgesehen, so dass in einer Fliessfertigung ein hoher Durchsatz erreichbar ist.

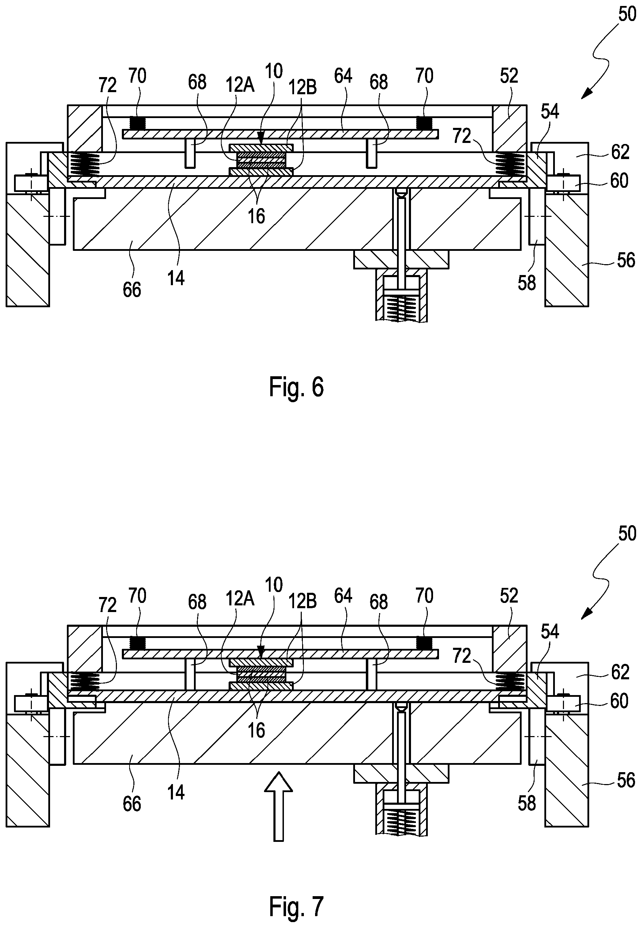

Nachfolgend wird mit Bezug auf Fig. 6 und 7 eine Lötvorrichtung 50 gemäß einem ersten Fall beschrieben. Vorteilhafterweise wird die im folgenden beschriebene Anschlagvorrichtung zumindest in der Abkühlkammer während der Kühlphase P4 eingesetzt, solange das Lot noch flüssig ist. Dabei kann ein Anpressdruck auf die Oberseite der Bauteile wirken.

Die Lötvorrichtung 50 umfasst einen Basisrahmen 54 und eine mit dem Basisrahmen 54 verbundene Trägereinheit 52. In den Basisrahmen 54 ist ein Substrat 14 einer Lötgruppe 10 eingelegt, welches von Druckfedern 72, die sich an der Trägereinheit 52 abstützen, in Richtung des Basisrahmens 54 vorgespannt wird. An der Trägereinheit 52 ist eine Andruckplatte 64 mittels Druckfedern 70 federnd gelagert. Die Andruckplatte 64 weist eine Anschlagvorrichtung mit mehreren Anschlagelementen 68 auf, welche mittels Verstellgewinden längenverstellbar an der Andruckplatte 64 befestigt sind. In der Basisplatte 66 integriert ist ein federbelasteter Temperatursensor in einem Durchgangsloch vorgesehen, der die Temperatur des Substrats 14 messen kann.

Nachdem die Lötgruppe 10 in den Basisrahmen 54 eingelegt wurde und die Trägereinheit 52 an dem Basisrahmen 54 befestigt wurde, kann die Einheit aus Trägereinheit 52 und Basisrahmen 54 in eine Halteeinheit 56 eingeschoben werden, wobei der Basisrahmen 54 mittels Führungsrollen 58, 60 und Halteleisten 62 fixiert wird.

Die Lötvorrichtung 50 umfasst ferner eine höhenverstellbare Basisplatte 66, welche durch den unten offenen Basisrahmen 54 hindurch direkt mit dem Substrat 14 in Kontakt treten kann.

Die Lötvorrichtung 50 kann in einer evakuierbaren Prozesskammer angeordnet sein, was nachfolgend noch näher beschrieben wird.

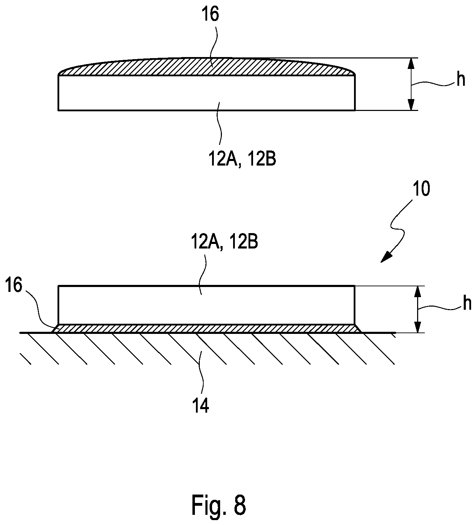

Die Basisplatte 66 und/oder die Andruckplatte 64 können mit nicht dargestellten Wärmequellen und/oder Wärmesenken verbunden sein, die es ermöglichen, die Lötgruppe 10 zu erhitzen bzw. abzukühlen. Wenn die Basisplatte 66 in Pfeilrichtung (Fig. 7) in Richtung auf die Andruckplatte 64 verstellt wird, wird der Schaltungsträgers 14 einschließlich der darauf gelagerten Bauteile 12A, 12B entgegen der Kraft der Druckfedern 72 aus dem Basisrahmen 54 ausgehoben. Nach einem bestimmten Verstellweg stößt das obere Bauteil 12B an die Andruckplatte 64 an, so dass die Lötgruppe 10 mit einer Presskraft beaufschlagt wird und die Bauteile 12A, 12B bzw. der Schaltungsträgers 14 zusammengepresst werden, bis die Anschlagelemente 68 mit ihrem freien Ende auf dem Schaltungsträger 14 anstoßen. In dieser in Fig. 7 dargestellten Position haben die Andruckplatte 64 und die Basisplatte 66 ihren Mindestabstand erreicht, so dass die Lötgruppe 10 nicht weiter zusammengepresst werden kann. Dadurch ist es möglich, gemäß Fig. 8 eine Lötgruppe 10 zu schaffen, welche eine definierte Höhe h aufweist.

Wenn anstelle des Schaltungsträgers 14 eine Hilfsträgerplatte (nicht dargestellt) in den Basisrahmen 54 eingelegt wird, auf den ein oder mehrere Bauteile 12A, 12B ohne Lotmaterial lediglich aufgelegt werden und auf die Bauteile 12A, 12B wiederum Lotmaterial 16 aufgelegt wird, ist es möglich, diese Bauteile 12A, 12B vor einem eigentlichen Herstellen einer Lötverbindung mit einem Überzug aus aufgeschmolzenem Lotmaterial 16 zu versehen, welcher ebenfalls eine definierte Höhe h aufweist (siehe Fig. 8). Zu diesem Zweck kann die Andruckplatte 64 an der Kontaktstelle zu dem Lotmaterial 16 mit einem Trennmittelüberzug versehen werden.

Mit Bezug auf Fig. 9 und 10 werden nun Lötvorrichtungen 150, 250 gemäß einem zweiten bzw. dritten Fall beschrieben. Die Lötvorrichtungen 150, 250 umfassen eine von der Umwelt abgeschlossene, evakuierbare Prozesskammer 74. In der Prozesskammer 74 ist eine nur schematisch dargestellte Halteeinheit 56 dargestellt, welche einen Basisrahmen 54 aufnimmt oder lagert. In dem Basisrahmen 54 ist wiederum ein Schaltungsträger 14 als Bestandteil von zwei Lötgruppen 10 gelagert.

Die Lötvorrichtung 150 (Fig. 9) umfasst eine Andruckplatte 64, die an der Prozesskammer 74 gelagert ist.

Die Lötvorrichtung 250 (Fig. 10) umfasst eine Andruckplatte 64, welche ähnlich wie bei dem ersten Fall (Fig. 6 und 7) an dem Basisrahmen 54 gelagert ist.

Die Lötvorrichtungen 150, 250 umfassen ferner eine höhenverstellbare Basisplatte 66, welche durch eine Öffnung im Basisrahmen 54 hindurch mit dem Substrat in Kontakt treten können. Das Substrat mit den beiden Lötgruppen 10 kann hierbei gegen die Andruckplatte 64 gepresst werden. An der Andruckplatte 64 sind Anschlagelemente 68 befestigt, die bei Erreichen eines Mindestabstands zwischen der Basisplatte 66 und der Andruckplatte 64 auf dem Schaltungsträger 14 aufsetzen, so dass die Lötgruppen 10 nicht weiter zusammengepresst werden und somit eine definierte Höhe aufweisen.

Die Anschlagelemente 68 können auch hier höhenverstellbar ausgeführt sein.

Die Andruckplatte 64 kann planar sein (Fig. 6, 7 und 10) oder gemäß einer Abwandlung einen oder mehrere hervorstehende Absätze 76 aufweisen, die mit den Lötgruppen 10 in Kontakt treten (Fig. 9). Die Absätze 76 können, wie in Fig. 9 dargestellt, einen etwas geringeren Querschnitt aufweisen, so dass sie nur mit einem Teil der Oberfläche des obersten Bauteils in Kontakt treten. Dadurch kann innerhalb der Bauteile ein Temperaturgradient erzeugt werden.

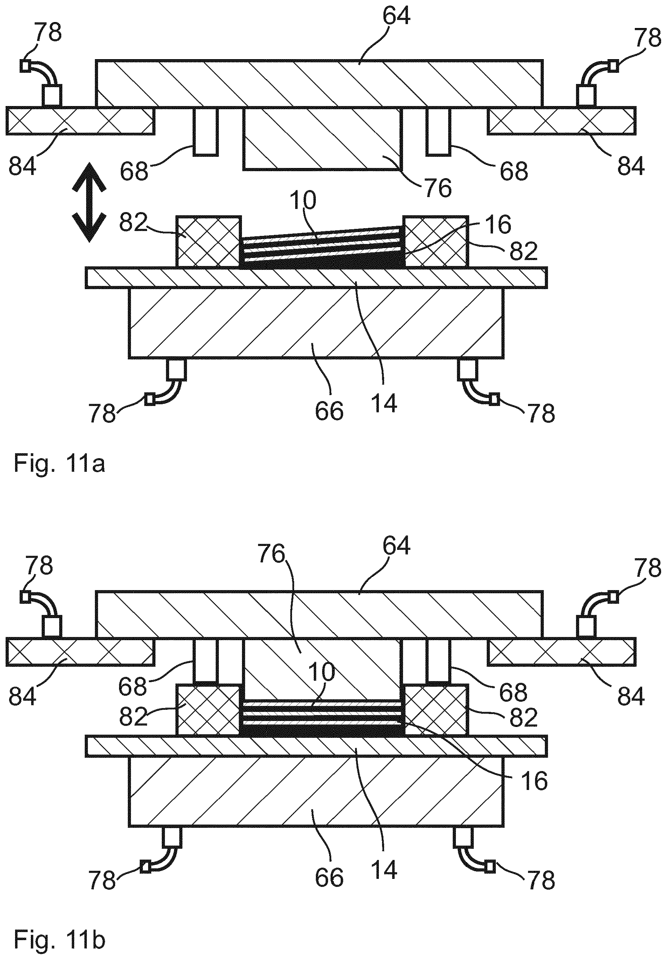

Vorteilhaft können durch die Andruckplatte verschiedenartige selektive Kühlkonzepte im Rahmen der horizontalen Ausrichtung erreicht werden. Selektives Kühlen bei Abschluss des Lötvorgangs ist im Stand der Technik bekannt, hierzu gibt es Konzepte, ein Lötgut von der Unterseite her mit Kühlmittel zu bedampfen oder mechanisch durch Kühlstifte zu kontaktieren. Damit wird erreicht, dass im Erstarrungsprozess das Lötmittel definiert von innen nach außen erstarrt und sich somit keine Lunker und Fehlstellen im Lötgefüge ergeben. In den weiteren Figs. 11 bis 14 (jeweils bei entfernter und anpressender Andruckplatte) werden verschiedene Konzepte dargestellt, eine mechanische Kontaktierung einer Kühl- oder Heizvorrichtung von einer Bauteiloberseite vorzunehmen, um selektiv ein Aufheizen oder Kühlen derart steuern zu können, dass der Erstarrungsprozess des Lötmittels selektiv auch von oben durch eine mechanische Verbindung durch die Andruckplatte beeinflusst werden kann.

Darstellt sind verschiedene Formen in den Figs 11 bis 14, die diverse Möglichkeiten aufzeigen, um selektiv Lötgruppen homogen oder inhomogen von einer Oberseite zu kühlen oder zu beheizen:
In der Fig. 11a (bei beabstandeter Andruckplatte 64) wird ein Absatz 76 der Andruckplatte 64, der kühl- oder beiheizbar ist, auf eine Lötgruppe 10, die aus aufeinander gestapelter Bauteile 12, die mittels Lotmaterial 16 verbunden sind aufgefahren, siehe Fig. 11b, um von oben zu kühlen / zu heizen. Der Anpressweg wird durch Anschlagelemente 68 begrenzt, die auf einer Oberseite eines Bauteilrahmens 82 oder JIGs aufsetzen. Die Anschlagplatte 64 wird durch eine Andruckvorrichtung-Halterahmen 84, der die Andruckplatte 64 umrahmt, geführt, wobei der Halterahmen 84 mittels Anschlüssen 78 eines Thermofluids wahlweise beheizt oder gekühlt werden kann. Das Thermofluid kann mit Glykol versetztes und unter Druck stehendes Wasser sein dass eine schnelle Temperatureinstellung der Andruckplatte ermöglicht. Die Basisplatte 66, die den Schaltungsträger 14 trägt, kann ebenfalls durch ein Thermofluid mittels Anschlüssen 78 beheizt oder gekühlt werden, so dass sowohl von oben wie von unten eine Temperatureinstellung ermöglicht wird. Vor der Druckbeaufschlagung ist Lotmaterial 16 inhomogen unter der Lötgruppe 10 verteilt, so dass sich eine verkippte Lage der Lötgruppe 10 gegenüber dem Schaltungsträger 14 und eine unterschiedliche Lotverteilung einstellt. Nach einer Druckbeaufschlagung in Fig. 11b kann eine horizontale Ausrichtung erreicht und Lotmaterial homogen innerhalb und unterhalb der Lötgruppe 10 erreicht werden.

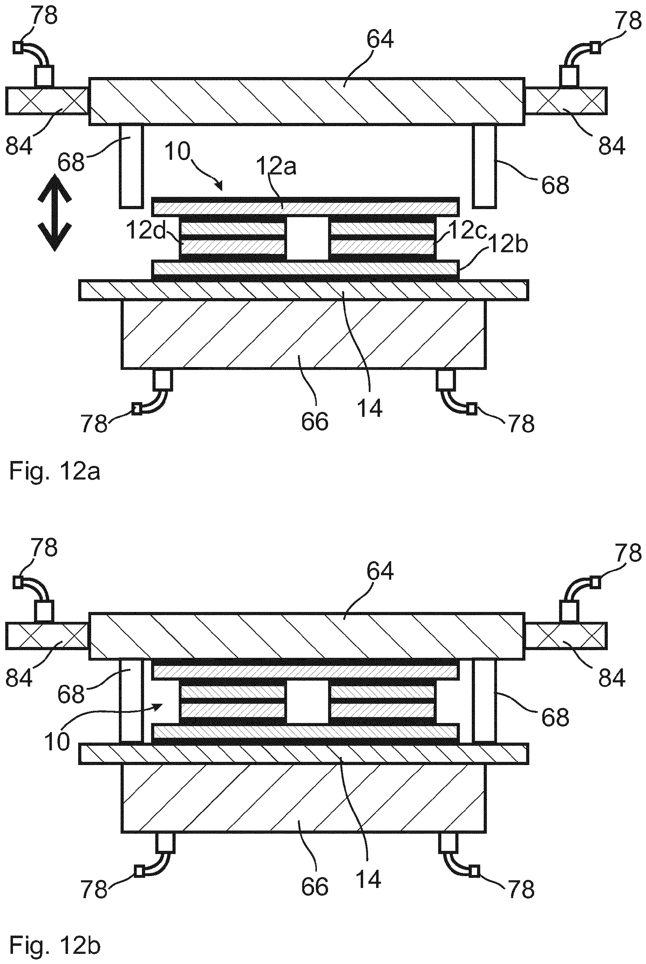

In einer gegenüber der Fig. 11 geänderten Konfiguration des Falles der Fig. 12a (beabstandete Andruckplatte 64) und Fig. 12b (Druckbeaufschlagung auf die Lötgruppe 10) wird eine Gesamtlötgruppe 10, die mehrere Bauelemente 12a bis 12d umfasst, durch eine einzelne Andruckplatte 64 verpresst. Wiederum ist die Andruckplatte 64 durch einen fluiddurchströmten Halterahmen 84 temperiert und die unterhalb der Lötgruppe 10 angeordnete Basisplatte 66 kann über den Schaltungsträger 14 ebenfalls temperiert werden. Die Lötgruppe weist mehrere benachbarte Bauteile 12c, 12d auf, die sandwichartig von größeren Bauteilen 12a, 12b als Sockel und Abdeckung umfasst sind. Durch Ausrichten der größeren Bauteile 12a, 12b, beispielsweise Kühlplatte und Grundplatine erfolgt eine Ausrichtung der kleineren Bauteile 12c, 12d.

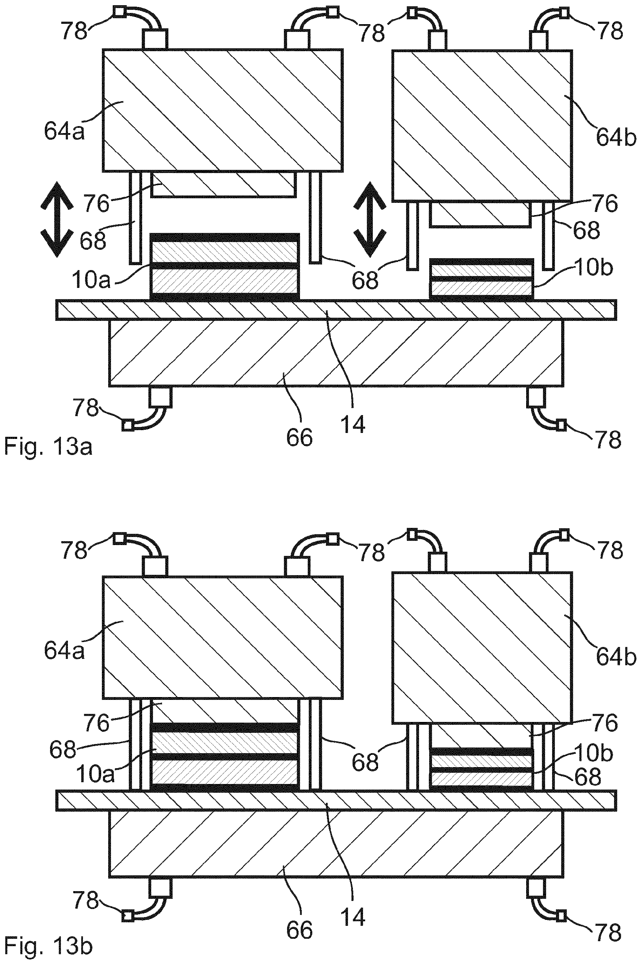

In der in den Figs. 13a, 13b (jeweils geöffnete und verpresste Darstellung) gezeigten Form einer Anschlagvorrichtung sind mehrere Andruckplatten 64a, 64b vorgesehen, die getrennt und individuell verfahren werden können, die aber auch gemeinsam auf einem Halterahmen 84 verfahren werden können.. Die Andruckplatten 64a, 64b umfassen jeweils individuell einstellbare Andruckelemente 68, die z.B. verschiedene Höhen aufweisen können, und sind mittels Fluidanschlüssen 78 getrennt oder gemeinsam temperierbar. Durch Absätze 76 können angepasst an Höhe und Größe der Oberfläche verschiedene Lötgruppen 10a, 10b auf einem Substratträger 14 verpresst werden. Hierdurch kann verschieden hohes Lötgut 10 selektiv gekühlt und ausgerichtet werden. Die Heiz- oder Kühlleistung ist individuell einstellbar an verschiedenen Andruckelementen. Die verschiedenen Anschlagelemente 76 sorgen für individuell einstellbare Anschlaghöhen der Andruckplatten 64a, 64b.

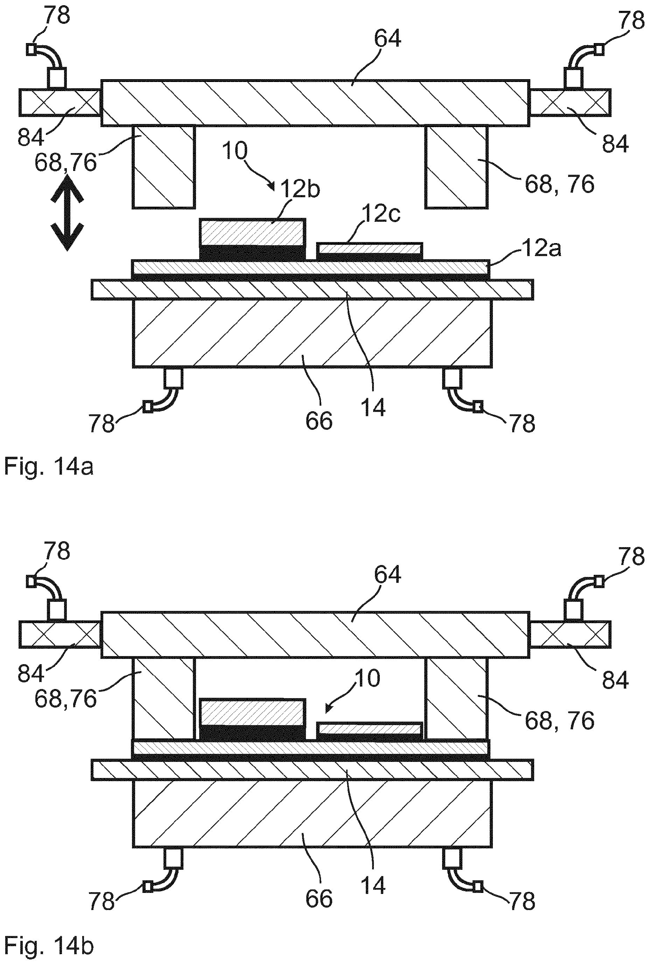

Schließlich zeigt die in Figs. 14a, 14b (geöffneter und verpresster Zustand) dargestellt Form eine Andruckplatte 64 ohne eigene Kühl- oder Heizeinrichtung. Die Andruckplatte 64 kann mittelbar über eine seitlich angeordnete Kühl- oder Heizeinrichtung, die in einem Halterahmen 84 der Andruckplatte 64 integriert ist, temperiert werden. So kann die Andruckplatte 64 beispielsweise in einer Niederhaltereinrichtung integriert ist, und/oder kann von einer unterhalb des Lötgut angeordneten Kühl- oder Heizeinrichtung temperiert werden. An der Andruckplatte sind vertikale Absätze 76 angeordnet, die selektiv an einzelnen Oberflächenbereichen der Lötgruppe 10 aufsetzen können, und die selektiv Wärme einführen oder entnehmen können. Die Absätze 76 dienen gleichzeitig als Anschlagelemente 68. Dabei können einzelne Bauelemente 12a verpresst und temperiert werden, während andere, druckempfindliche Bauelemente 12b, 12c der Lötgruppe 10 ausgespart bleiben.

Die in den Figs. 11-14 dargestellten Formen können einzeln oder kombiniert eingesetzt werden, und können sich synergetisch ergänzen und kombinieren, oder einzeln ihre vorteilhafte Wirkung entfalten.

Die Bauteile 12A, 12B können bei allen Formen der Lötvorrichtung 50, 150, 250 (Fig. 6 bis 14) untereinander, mit dem Lotmaterial 16 und/oder mit dem Schaltungsträger bzw. Substrat 14 in der mit Bezug auf Fig. 1 bis 5 beschriebenen Weise mittels Haftmaterial 18 provisorisch verbunden werden.

### Bezugszeichenliste

- 10: Lötgruppe
- 12A, 12B: Bauteil
- 14: Substrat / Schaltungsträger
- 16: Lotmaterial
- 18: Haftmaterial
- 50, 150, 250: Lötvorrichtung
- 52: Trägereinheit
- 54: Basisrahmen
- 56: Halteeinheit
- 58, 60: Führungsrolle
- 62: Halteleiste
- 64: Andruckplatte
- 66: Basisplatte
- 68: Anschlagelement
- 70, 72: Druckfeder
- 74: Prozesskammer
- 76: Absatz
- 78: Temperierfluid-Anschluss
- 82: Bauteilrahmen
- 84: Andruckvorrichtungs-Halterahmen

- A, B, B', C, D: Prozesspunkt
- L: Liquiduskurve
- N: Stickstoffatmosphäre
- P: Phasengrenzlinie
- P1: Vorheizphase
- P2: Reinigungsphase
- P3: Schmelzphase
- P4: Kühlphase
- R: Reinigungsmittelatmosphäre
- T: Temperaturkurve
- V: Vakuum

## Patentansprüche

1. Verfahren zum Herstellen einer Lötverbindung zwischen mehreren Bauteilen (12A, 12B) in einer von der Umgebung abgeschlossenen Prozesskammer (74) durch Erhitzen und Aufschmelzen von Lotmaterial (16), welches zwischen den zu verbindenden Bauteilen (12A, 12B) angeordnet ist, wobei die zu verbindenden Bauteile (12A, 12B) provisorisch mit einem Haftmaterial (18) zu einer Lötgruppe (10) verbunden werden, in welcher die Bauteile (12A, 12B) relativ zueinander in einer Fügeposition fixiert sind, **dadurch gekennzeichnet, dass** die Lötgruppe (10) auf eine Zwischentemperatur erhitzt wird, welche niedriger als die Schmelztemperatur des Lotmaterials (16) bei atmosphärischem Druck ist, und dass der Druck in der Prozesskammer (74) auf einen Druck unterhalb des Verdampfungsdrucks des Haftmaterials (18) bei der Zwischentemperatur abgesenkt wird, so dass das Haftmaterial (18) verdampft, wobei zunächst der Druck in der Prozesskammer (74) auf einen Druck oberhalb des Verdampfungsdrucks des Haftmaterials (18) bei der Zwischentemperatur abgesenkt wird, so dass das Haftmaterial (18) noch nicht verdampft, nachfolgend ein Reinigungsmittel, insbesondere Methansäure, Wasserstoff oder ein Plasma, zum Reinigen der Lötgruppe (10) in die Prozesskammer (74) eingeleitet wird, und weiter nachfolgend der Druck in der Prozesskammer (74) auf einen Druck unterhalb des Verdampfungsdrucks des Haftmaterials (18) bei der Zwischentemperatur abgesenkt wird.

2. Verfahren nach Anspruch 1, **dadurch gekennzeichnet, dass** das Haftmaterial (18) derart gewählt ist, dass es während des Herstellens der Lötverbindung verdampft.

3. Verfahren nach Anspruch 2, **dadurch gekennzeichnet, dass** die Verdampfungstemperatur des Haftmaterials (18) bei einem Verdampfungsdruck, welcher geringer ist als der atmosphärische Druck, niedriger ist als die Schmelztemperatur des Lotmaterials (16) bei atmosphärischem Druck.

4. Verfahren nach Anspruch 1, **dadurch gekennzeichnet, dass** die Zwischentemperatur während des Absenkens des Drucks in der Prozesskammer (74) auf einen Druck unterhalb des Verdampfungsdrucks des Haftmaterials (18) zumindest bis zum vollständigen Verdampfen des Haftmaterials (18) auf einem vorgegebenen Temperaturwert oder innerhalb eines vorgegebenen Temperaturbereichs gehalten wird.

5. Verfahren nach einem der vorangegangenen Ansprüche, **dadurch gekennzeichnet, dass** das Haftmaterial (18) im Bereich von Kanten und/oder Ecken und/oder Mitte der zu verbindenden Bauteile (12A, 12B) und/oder des Lotmaterials (16) angeordnet wird.

6. Verfahren nach einem der vorangegangenen Ansprüche, **dadurch gekennzeichnet, dass** das Aufschmelzen des Lotmaterials (16) nach dem Verdampfen des Haftmaterials (18) erfolgt.

7. Verfahren nach einem der vorangegangenen Ansprüche, **dadurch gekennzeichnet, dass** das Haftmaterial (18) flüssig oder pastös ist und insbesondere einen Terpenalkohol, insbesondere Isobornyl-Cyclohexanol, umfasst.

8. Verfahren nach einem der vorangegangenen Ansprüche, **dadurch gekennzeichnet, dass** die Lötgruppe (10) zumindest während des Aufschmelzens des Lotmaterials (16) in einer in der Prozesskammer (74) angeordneten Lötvorrichtung (50, 150, 250) aufgenommen ist, wobei die Lötvorrichtung (50, 150, 250) eine Basisplatte (66) und eine Andruckplatte (64), zwischen denen die Lötgruppe (10) aufgenommen ist und welche zum Ausüben einer Presskraft auf die Lötgruppe (10) relativ zueinander bezüglich ihres Abstandes verstellbar sind, sowie eine Anschlagvorrichtung aufweist, welche den Abstand zwischen der Basisplatte (66) und der Andruckplatte (64) auf einen Mindestabstand begrenzt, so dass die Lötgruppe (10) nach dem Aufschmelzen des Lotmaterials (16) eine vorgegebene Dicke aufweist.

9. Verfahren nach Anspruch 8, **dadurch gekennzeichnet, dass** die Anschlagvorrichtung an der Basisplatte (66) oder der Andruckplatte (64) angeordnet ist.

10. Verfahren nach Anspruch 8 oder 9, **dadurch gekennzeichnet, dass** die Anschlagvorrichtung verstellbar ist, so dass der Mindestabstand einstellbar ist.

11. Verfahren nach einem der Ansprüche 8 bis 10, **dadurch gekennzeichnet, dass** die Anschlagvorrichtung mehrere, insbesondere längenverstellbare Anschlagelemente (68) umfasst.

12. Verfahren nach Anspruch 11, **dadurch gekennzeichnet, dass** jedes Anschlagelement eine Verstelleinrichtung aufweist, welches vorzugsweise mit einem an der Basisplatte (66) oder der Andruckplatte (64) vorgesehenen Komplementärverstelleinrichtung zusammenwirkt.

13. Verfahren nach Anspruch 11 oder 12, **dadurch gekennzeichnet, dass** die Anschlagelemente (68) derart angeordnet sind, dass sich diese bei Erreichen des Mindestabstandes mit einem jeweiligen freien Ende an einem Bauteil (12A, 12B, 14) der Lötgruppe (10), an einem eines der Bauteile (12A, 12B, 14) tragenden Basisrahmen (54) oder der Basisplatte (66) abstützen.

14. Verfahren nach einem der Ansprüche 8 bis 13, **dadurch gekennzeichnet, dass** die Basisplatte (66) und/oder die Andruckplatte (64) heizbar und/oder kühlbar sind.

15. Verfahren nach einem der Ansprüche 8 bis 14, **dadurch gekennzeichnet, dass** die Lötvorrichtung (50, 150, 250) eine Trägereinheit (52) aufweist, an dem die Andruckplatte (64) direkt oder indirekt federnd abgestützt oder gelagert ist.

16. Verfahren nach Anspruch 15, **dadurch gekennzeichnet, dass** die Federkraft, welche die Andruckplatte (64) auf die Lötgruppe (10) ausübt, einstellbar ist.

17. Verfahren nach Anspruch 15 oder 16, **dadurch gekennzeichnet, dass** die Basisplatte (66) relativ zu der Trägereinheit (52) verstellbar ist.

18. Verfahren nach einem der Ansprüche 8 bis 17, **dadurch gekennzeichnet, dass** die der Basisplatte (66) zugeordnete Seite der Andruckplatte (64) planar ist oder zumindest einen hervorstehenden, insbesondere planaren Absatz (76) aufweist, welcher in Kontakt mit der Lötgruppe (10) steht.

## Claims

1. A method for producing a solder connection between a plurality of components (12A, 12B) in a process chamber (74) sealed off from its surroundings by heating and melting solder material (16) which is arranged between the components (12A, 12B) to be connected, the components (12A, 12B) to be connected being provisionally connected with a bonding material (18) to form a solder group (10) in which the components (12A, 12B) are fixed relative to one another in a joining position, **characterised in that** the solder group (10) is heated to an intermediate temperature which is lower than the melting temperature of the solder material (16) at atmospheric pressure, and **in that** the pressure in the process chamber (74) is reduced to a pressure below the evaporation pressure of the bonding material (18) at the intermediate temperature, such that the bonding material (18) evaporates, wherein the pressure in the process chamber (74) is initially reduced to a pressure above the evaporation pressure of the bonding material (18) at the intermediate temperature, such that the bonding material (18) does not yet evaporate, subsequently a cleaning agent, in particular methanoic acid, hydrogen or a plasma, is introduced into the process chamber (74) to clean the solder group (10), and further subsequently the pressure in the process chamber (74) is reduced to a pressure below the evaporation pressure of the bonding material (18) at the intermediate temperature.

2. A method according to claim 1, **characterised in that** the bonding material (18) is selected such that it evaporates during production of the solder connection.

3. A method according to claim 2, **characterised in that,** at an evaporation pressure which is lower than atmospheric pressure, the evaporation temperature of the bonding material (18) is lower than the melting temperature of the solder material (16) at atmospheric pressure.

4. A method according to claim 1, **characterised in that** the intermediate temperature while the pressure in the process chamber (74) is being reduced to a pressure below the evaporation pressure of the bonding material (18) is maintained at a predetermined temperature value or within a predetermined temperature range at least until evaporation of the bonding material (18) is complete.

5. A method according to one of the preceding claims, **characterised in that** the bonding material (18) is arranged in the region of edges and/or corners and/or the centre of the components to be connected (12A, 12B) and/or of the solder material (16).

6. A method according to one of the preceding claims, **characterised in that** the solder material (16) melts once the bonding material has evaporated (18).

7. A method according to one of the preceding claims, **characterised in that** the bonding material (18) is liquid or pasty and in particular comprises a terpene alcohol, in particular isobornyl cyclohexanol.

8. A method according to one of the preceding claims, **characterised in that,** at least while the solder material (16) is melting, the solder group (10) is received in soldering apparatus (50, 150, 250) arranged in the process chamber (74), wherein the soldering apparatus (50, 150, 250) has a base plate (66) and a pressure plate (64), between which is received the solder group (10) and which are adjustable relative to one another with regard to the spacing thereof for exerting a pressure force on the solder group (10), and has a stop apparatus which limits the spacing between the base plate (66) and the pressure plate (64) to a minimum spacing, such that, once the solder material (16) has melted, the solder group (10) has a predetermined thickness.

9. A method according to claim 8, **characterised in that** the stop apparatus is arranged on the base plate (66) or the pressure plate (64).

10. A method according to claim 8 or 9, **characterised in that** the stop apparatus is adjustable such that the minimum spacing can be set.

11. A method according to one of claims 8 to 10, **characterised in that** the stop apparatus comprises a plurality of in particular length-adjustable stop elements (68).

12. A method according to claim 11, **characterised in that** each stop element has an adjusting device which preferably interacts with a complementary adjusting device provided on the base plate (66) or the pressure plate (64).

13. A method according to claim 11 or 12, **characterised in that** the stop elements (68) are arranged such that, on reaching the minimum spacing, they bear with a respective free end against a component (12A, 12B, 14) of the solder group (10), against a base frame (54) carrying one of the components (12A, 12B, 14) or against the base plate (66).

14. A method according to one of claims 8 to 13, **characterised in that** the base plate (66) and/or the pressure plate (64) are heatable and/or coolable.

15. A method according to one of claims 8 to 14, **characterised in that** the soldering apparatus (50, 150, 250) has a carrier unit (52) on which the pressure plate (64) is directly or indirectly spring-supported or spring-mounted.

16. A method according to claim 15, **characterised in that** the spring force which the pressure plate (64) exerts on the solder group (10) can be set.

17. A method according to claim 15 or 16, **characterised in that** the base plate (66) is adjustable relative to the carrier unit (52).

18. A method according to one of claims 8 to 17, **characterised in that** the side of the pressure plate (64) associated with the base plate (66) is planar or has at least one projecting, in particular planar, step (76) which is in contact with the solder group (10).

## Revendications

1. Procédé pour réaliser une jonction par brasage entre plusieurs composants (12A, 12B) dans une chambre de processus (74) isolée de l'environnement, en chauffant et faisant fondre du matériau d'apport (16) qui est disposé entre les composants à assembler (12A, 12B), sachant que les composants à assembler (12A, 12 B) sont reliés provisoirement au moyen d'un matériau adhésif (18) pour former un groupe de brasage (10) dans lequel les composants (12A, 12B) sont fixés les uns par rapport aux autres dans une position de jonction, **caractérisé en ce que** le groupe de brasage (10) est chauffé à une température intermédiaire qui est inférieure à la température de fusion du matériau d'apport (16) à la température atmosphérique, et que la pression dans la chambre de processus (74) est abaissée à une pression en dessous de la pression d'évaporation du matériau adhésif (18) à la température intermédiaire de sorte que le matériau adhésif (18) s'évapore, sachant que tout d'abord, la pression dans la chambre de processus (74) est abaissée à une pression au-dessus de la pression d'évaporation du matériau adhésif (18) à la température intermédiaire de sorte que le matériau adhésif (18) ne s'évapore pas encore, qu'ensuite un agent nettoyant, notamment de l'acide formique, de l'hydrogène ou un plasma, est introduit dans la chambre de processus (74) pour nettoyer le groupe de brasage (10), et qu'après, la pression dans la chambre de processus (74) est abaissée à une pression en dessous de la pression d'évaporation du matériau adhésif (18) à la température intermédiaire.

2. Procédé selon la revendication 1, **caractérisé en ce que** le matériau adhésif (18) est sélectionné de manière à s'évaporer pendant la réalisation de la jonction par brasage.

3. Procédé selon la revendication 2, **caractérisé en ce que** la température d'évaporation du matériau adhésif (18) à une pression d'évaporation inférieure à la pression atmosphérique est inférieure à la température de fusion du matériau d'apport (16) à la pression atmosphérique.

4. Procédé selon la revendication 1, **caractérisé en ce que** la température intermédiaire, pendant l'abaissement de la pression dans la chambre de processus (74) à une pression en dessous de la pression d'évaporation du matériau adhésif (18), est maintenue à une valeur de température prédéfinie ou dans une plage de température prédéfinie, au moins jusqu'à l'évaporation complète du matériau adhésif (18).

5. Procédé selon une des revendications précédentes, **caractérisé en ce que** le matériau adhésif (18) est disposé au niveau des arêtes et/ou coins et/ou au centre des composants à assembler (12A, 12B) et/ou du matériau d'apport (16).

6. Procédé selon une des revendications précédentes, **caractérisé en ce que** la fonte du matériau d'apport (16) a lieu après l'évaporation du matériau adhésif (18).

7. Procédé selon une des revendications précédentes, **caractérisé en ce que** le matériau adhésif (18) est liquide ou pâteux et comprend notamment un alcool terpénique, notamment du cyclohexanol isobornyle.

8. Procédé selon une des revendications précédentes, **caractérisé en ce que** le groupe de brasage (10) est logé dans un dispositif de brasage (50, 150, 250) disposé dans la chambre de processus (74), au moins pendant la fonte du matériau d'apport (16), sachant que le dispositif de brasage (50, 150, 250) présente une plaque de base (66) et une plaque de pression (64) entre lesquelles le groupe de brasage (10) est logé et qui sont ajustables l'une par rapport à l'autre au niveau de leur écartement afin d'exercer une force de pression sur le groupe de brasage (10), ainsi qu'un dispositif de butée qui limite l'écart entre la plaque de base (66) et la plaque de pression (64) à un écart minimal de sorte que le groupe de brasage (10) présente une épaisseur prédéfinie après la fonte du matériau d'apport (16).

9. Procédé selon la revendication 8, **caractérisé en ce que** le dispositif de butée est disposé sur la plaque de base (66) ou la plaque de pression (64).

10. Procédé selon la revendication 8 ou 9, **caractérisé en ce que** le dispositif de butée est ajustable de manière à ce que l'écart minimal soit réglable.

11. Procédé selon une des revendications 8 à 10, **caractérisé en ce que** le dispositif de butée comprend plusieurs éléments de butée (68) notamment réglables en longueur.

12. Procédé selon la revendication 11, **caractérisé en ce que** chaque élément de butée présente un dispositif d'ajustage qui interagit de préférence avec un dispositif d'ajustage complémentaire prévu sur la plaque de base (66) ou la plaque de pression (64).

13. Procédé selon la revendication 11 ou 12, **caractérisé en ce que** les éléments de butée (68) sont disposés de telle sorte qu'une fois l'écart minimal atteint, une de leurs extrémités respectives libres s'appuie contre un composant (12A, 12B, 14) du groupe de brasage (10), contre un cadre de base (54) portant un des composants (12A, 12B, 14) ou contre la plaque de base (66).

14. Procédé selon une des revendications 8 à 13, **caractérisé en ce que** la plaque de base (66) et/ou la plaque de pression (64) sont chauffables et/ou refroidissables.

15. Procédé selon une des revendications 8 à 14, **caractérisé en ce que** le dispositif de brasage (50, 150, 250) présente une unité support (52) sur laquelle la plaque de pression (64) s'appuie ou est montée directement ou indirectement de manière élastique.

16. Procédé selon la revendication 15, **caractérisé en ce que** la tension de ressort qu'exerce la plaque de pression (64) sur le groupe de brasage (10) est réglable.

17. Procédé selon la revendication 15 ou 16, **caractérisé en ce que** la plaque de base (66) est réglable par rapport à l'unité support (52).

18. Procédé selon une des revendications 8 à 17, **caractérisé en ce que** la face de la plaque de pression (64) tournée vers la plaque de base (66) est plane ou présente au moins un épaulement (76) saillant, notamment plan, qui touche le groupe de brasage (10).
